# EUROPÄISCHE PATENTSCHRIFT

(11) **EP 0 721 697 B1**
(45) Veröffentlichungstag und Bekanntmachung des Hinweises auf die Patenterteilung: **24.11.1999**
(21) Anmeldenummer: 95926956.4
(22) Anmeldetag: 19.07.1995
(51) Int. Cl.: H03D 9/06

(54) **MILLIMETERWELLEN-MISCHER IN FENSTERTECHNIK**
DWARF WAVES MIXER REALIZED BY WINDOWING
MELANGEUR D'ONDES MILLIMETRIQUES REALISE PAR FENETRAGE

(30) Priorität: 27.07.1994 DE 4426543
(43) Veröffentlichungstag der Anmeldung: 17.07.1996
(73) Patentinhaber: Daimler-Benz Aerospace Aktiengesellschaft, 81663 München (DE)
(72) Erfinder: RUST, Stefan, D-89250 Senden (DE)
(74) Vertreter: Fröhling, Werner Otto, Dr.
(86) Internationale Anmeldenummer: EP9502844
(87) Internationale Veröffentlichungsnummer: WO9603801

(56) Entgegenhaltungen:
- EP-A- 0 186 295
- DE-A- 3 637 827
- DE-A- 3 738 262
- US-A- 4 276 655

## Beschreibung

Die Erfindung betrifft einen Millimeterwellen-Mischer in Fenstertechnik gemäß dem Oberbegriff des Patentanspruchs 1.

Aufgrund der heute steigenden Anforderungen an die Leistungsfähigkeit von Millimeterwellen-Mischern bei gleichzeitig zunehmender Miniaturisierungsforderung sowie steigendem Kostendruck ist es erforderlich, derartige Mischer konzeptionell angepaßt in neuen Technologien umzusetzen.

Es wurde bereits eine Technologie vorgeschlagen, die diesen Ansprüchen genügt und allgemein mit dem Begriff "Fenstertechnik" umschrieben ist. In dieser Technologie gefertigte Mischer weisen i.a. ein einseitig metallisiertes Substrat auf, das in einem Hohlleiter angeordnet ist.

Weiterhin ist allgemein bekannt, dap bei Gegentakt-Mischern Mischerdioden für ein Lokaloszillator(LO)-Signal parallel zu schalten sind und daß das in die Zwischen-Frequenzlage zu mischende Hochfrequenz-Signal in Serie zu schalten ist. Bei der Realisierung von Eingangsschaltungen ist daher darauf zu achten, daß der LO-Quellwiderstand an den halben, der Signal-Quellwiderstand an den doppelten reellen Diodenwiderstand anzupassen ist.

Da dabei sowohl Signal- als auch LO-Leistung vom zugehörigen Hohlleiter - dessen Quellwiderstand ungefähr dem der Mischerdioden entspricht - zugeführt wird, muß bei der LO-Eingangsschaltung ein um den Faktor 4 größeres Transformationsverhältnis zwischen Quellimpedanz und Diodenimpedanz realisiert werden als bei der Signal-Eingangsschaltung. Da im Millimeterwellen-Frequenzbereich der Betrag des Wirkwiderstandes einer Mischer-Diode gewöhnlich kleiner als 10 Ohm ist und der Wellenwiderstand handelsüblicher Hohlleiter ca. 400 Ohm beträgt, muß mit der LO-Eingangsschaltung ein Impedanz-Transformationsverhältnis von 1 : 80 realisiert werden.

Dies läßt sich nur mit einer Resonanz-Transformation realisieren. Sind LO-Hohlleiter und Signalhohlleiter mehrere Wellenlängen voneinander entfernt, reduziert sich die Bandbreite der LO-Eingangsschaltung sehr schnell. Maßnahmen zur Verbesserung der LO-Eingangsschaltung am Ort der Mischer-Dioden haben gewöhnlich Auswirkungen auf die Signal-Eingangsschaltung.

Weiterhin ist allgemein bekannt, daß, um ein niederohmiges Bauelement breitbandig an eine vorgegebene Quellimpedanz anzupassen, die Fußpunkt-Impedanz (Impedanz zwischen Anschlußmasse und Bauelement) niedrig sein muß.

Es ist nun erstrebenswert, die Vorteile der Fenstertechnik, nämlich den möglichen hohen Grad der Miniaturisierung bei gleichzeitiger Einhaltung bzw. gleichzeitigem Übertreffen der bisher üblichen elektrischen Anforderungen (hohe Störfestigkeit, Breitbandigkeit usw.), auf weitere Baugruppen der Millimeterwellentechnik zu übertragen.

So liegt der Erfindung die Aufgabe zugrunde, einen kleinen Millimeterwellen-Mischer in Fenstertechnik vorzuschlagen, der leicht, materialsparend und kostengünstig herstellbar ist. Ferner sollte dieser Mischer breitbandig, und störfest ausfallen.

Die erfindungsgemäße Lösung dieser Aufgabe wird durch die kennzeichnenden Merkmale des Patentanspruchs 1 wiedergegeben. Die weiteren Ansprüche enthalten vorteilhafte Ausund Weiterbildungen der Erfindung.

Erfindungsgemäß wird die Aufgabe dadurch gelöst, daß aus der Metallisierung des Substrates eine Koplanarleitung herausgearbeitet ist, welche die Metallisierung in zwei Teile aufteilt, daß die Koplanarleitung an den Schmalseiten des Hohlleiters herausgeführt ist, daß die Koplanar-leitung mit jeder der beiden Teile über eine erste bzw. zweite Diode verbunden ist und daß mindestens zwei Schlitzleitungen parallel zu den Breitseiten des Hohlleiters aus der Metallisierung herausgearbeitet sind.

Von Vorteil ist hierbei, daß der erfindungsgemäße Mischer einen hohen Miniaturisierungsgrad aufweist. Dadurch sinken nämlich z.B. die Herstellungskosten bei der Massenfertigung des erfindungsgemäßen Mischers erheblich. Weitere Vorteile liegen in der Breitbandigkeit und der Störfestigkeit.

Anhand der Zeichnungen wird nachfolgend die Erfindung exemplarisch verdeutlicht, wobei gleiche Bezugszeichen in verschiedenen Figuren gleiche Bezugselemente bezeichnen.

Es zeigen:
- FIG. 1: eine bevorzugte Ausführungsform des erfindungsgemäßen Millimeterwellen-Mischers in Frontalperspektive,
- FIG. 2: einen Querschnitt durch die bevorzugte Ausführungsform des erfindungsgemäßen Millimeterwellen-Mischers nach FIG. 1.

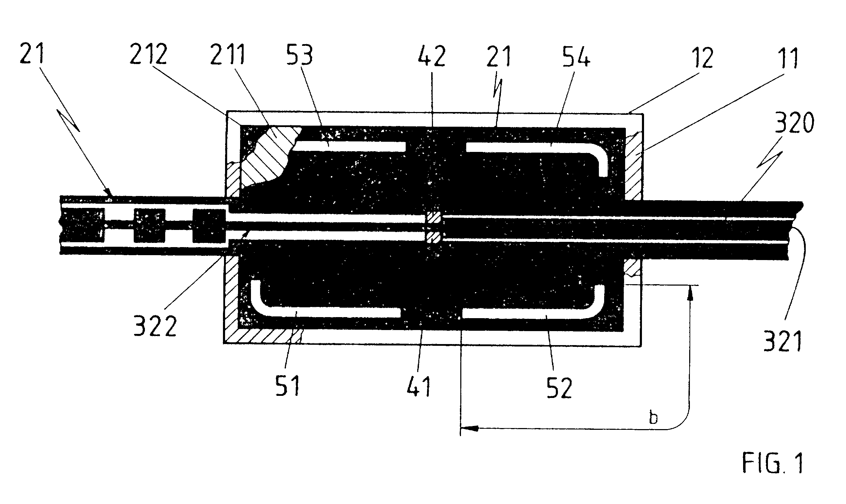

Der Millimeterwellen-Mischer 21 in FIG. 1 weist eine Metallisierung 212 auf einem Substrat 211 auf, welches in einem Hohlleiter senkrecht zu dessen Hohlleiterhauptachse ausgebildet ist. Der Hohlleiter setzt sich, wie es in der Fenstertechnik üblich ist, aus einem ersten und einem zweiten Hohlleiter 11, 12 gleicher Ausrichtung und gleicher lichten Weite zusammen. Zwischen dem ersten und dem zweiten Hohlleiter 11, 12 ist das Substrat 211 fixiert.

Das Substrat 211 ist an den beiden Schmalseiten des ersten Hohlleiters 11 herausgeführt. Der erste Hohlleiter 11 weist dabei, in einem geringen Abstand vom Substrat 211 aus gesehen, einen Hohlleiterkurzschluß 121 auf. Der Abstand zwischen dem Kurzschluß des ersten Hohlleiters 11 und dem Substrat 211 beträgt in etwa λ/4, wobei λ die mittlere Betriebswellenlänge darstellt.

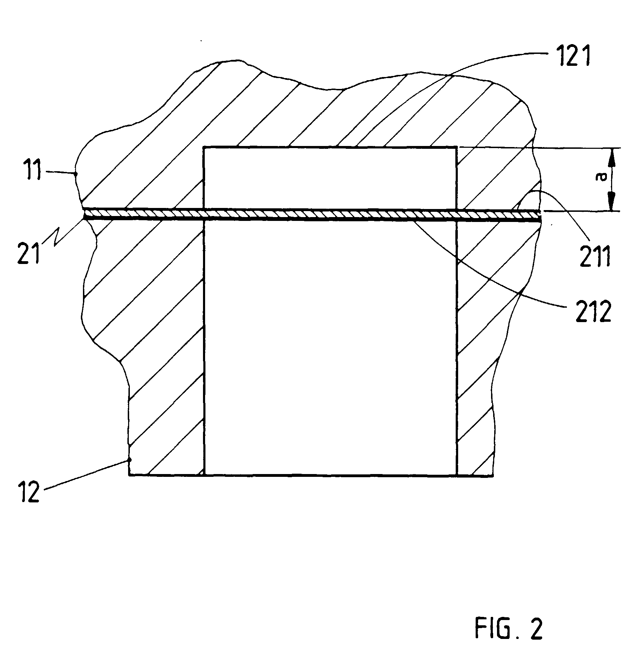

In der Querschnittsdarstellung in FIG. 2 durch die bevorzugte Ausführungsform des erfindungsgemäßen Millimeterwellen-Mischers nach FIG. 1 ist dieser Abstand mit a bezeichnet. Wie aus FIG. 1 weiterhin hervorgeht, ist aus der Metallisierung 212 des Substrats 211 eine Koplanarleitung 320 herausgearbeitet, welche die Metallisierung 212 in zwei Teile, die vorzugsweise in etwa gleich groß sind, aufteilt.

Die Koplanarleitung 320 ist mit jeder der beiden Hälften über eine erste bzw. zweite Diode 41, 42 verbunden.

Ebenfalls aus der Metallisierung 212 sind mindestens zwei Schlitzleitungen, die beispielsweise spiegelsymmetrisch zur Koplanarleitung 320 herausgearbeitet sind. Besonders günstige elektrische Eigenschaften, z.B. hinsichtlich der Anpassung des Hohlleiters (12) an die Mischer-Dioden (41, 42), ergeben sich, wenn, wie in FIG. 1 eingezeichnet, vier zueinander spiegelsymmetrisch angeordnete Schlitzleitungen 51, 52, 53, 54 aus der Metallisierung 212 herausgearbeitet sind. Hierbei sind die Schlitzleitungen in etwa 1-förmig realisiert. Das kürzere Stück der 1-Form verläuft jeweils in etwa parallel zu einer der Schmalseiten des ersten Hohlleiters 11.

Das längere Stück der jeweiligen 1-förmigen Schlitzleitungen 51, 52, 53, 54 verläuft in etwa parallel zu einer der Breitseiten des ersten Hohlleiters 11. Ferner sind die längeren Stücke der Schlitzleitungen 51, 52, 53, 54 in etwa parallel zur Koplanarleitung 320 ausgebildet. Diese Teilstücke der 1-förmigen Schlitzleitungen 51, 52, 53, 54 weisen jeweils eine Länge von in etwa λ/2 auf, wobei λ die mittlere Betriebswellenlänge darstellt.

Die Koplanarleitung 320 in FIG. 1 ist durch eine erste und eine zweite, zueinander axial ausgerichtete Koplanarleitung 321, 322 realisiert, deren Leitungsbreite unterschiedlich ist.

Der Koppelpunkt liegt dabei in etwa im Flächenmittelpunkt der metallisierten Substratseite 211. Der Koppelpunkt der ersten und der zweiten Koplanarleitung 321, 322 fällt mit dem Koppelpunkt der ersten und zweiten Diode 41, 42 zusammen. Die Kopplung erfolgt jeweils an einem Ende der Dioden galvanisch. Der jeweilige Diodenfußpunkt (anderes, mit der Metallisierung 212 galvanisch verbundenes Ende der Dioden 41 bzw. 42) der Dioden 41, 42 weist gegenüber der jeweils nächstliegenden Breitseite des zweiten Hohlleiters 12 eine induktive Verbindung auf.

Prinzipiell funktioniert die bevorzugte Ausführungsform des erfindungsgemäßen Millimeterwellen-Mischers wie folgt.

Eine LO-Leistung wird in der Nähe der Dioden 41, 42 im Bereich innerhalb des zweiten Hohlleiters 12 (Signalhohlleiters) über die Koplanar-Leitung 320 geführt, wo durch die genügend große metallisierte Fläche der Metallisierung 212 und der galvanischen Verbindung dieser mit dem Hohlleitergehäuse die notwendige Niederohmigkeit des koplanaren Außenleiters hergestellt ist. Die metallische Fläche der Metallisierung 212 für die Realisierung des Außenleiters der Koplanar-Leitung 320 der LO-Zuführung nimmt einen erheblichen Teil der Querschnittsfläche des zweiten Hohlleiters 12 ein, welche die Transmission der Signal-Leistung in dem hinter der Mischerschaltung kurzgeschlossenen ersten Hohlleiter 11 (Hohlleiterkurzschluß 121) in hohem Maße einschränkt. Ein solcher, durch die Schaltung transmittierter Signalleistungsanteil wird jedoch benötigt, um bei der Betriebsfrequenz nach Reflexion am Hohlleiterkurzschluß 121 des ca. λ/4 langen Hohlleiterstückes die in der Schaltung vorhandene Blindleistung zu kompensieren. In der Nähe und parallel zu jeder der beiden Hohlleiterbreitseiten des ersten Hohlleiters 11 sind die Schlitzleitungen 51, 52, 53, 54 angebracht, welche bei der Mittenfrequenz von in etwa b = λ/2 lang sind und bedingt durch die Feldverteilung des das Hochfrequenz-Signal führenden ersten und zweiten Hohlleiters 11, 12 angeregt werden. Das in der Mitte dieser beidseitig kurzgeschlossenen Schlitzungen 51, 52, 53, 54 entstehende elektrische Feld koppelt, wie bei einer Resonanzblende, Signalleistung in den kurzgeschlossenen Teil des ersten Hohlleiters 11 hinter der Mischer-Schaltung. Da die Transmission dabei frequenzabhängig ist, dienen die Schlitzleitungen 51, 52, 53, 54 als Abstimmittel bei der Realisierung der Signal-Eingangsschaltung. Je nachdem, ob man ihre Länge so wählt, daß die Resonanzfrequenz oberhalb oder unterhalb der Betriebsfrequenz liegt, läßt sich bereits mit ihnen ein Teil der Mischer-Reaktanz kompensieren. Unter Einbeziehung der Hohlleiterkurzschlußlänge hinter dem Substrat kann somit die Signal-Eingangsschaltung zweikreisig und damit breitbandig realisiert werden.

Die Zuführung der bei der Mischung beteiligten zwei Hochfrequenz-Signale (Nutzsignal, LO-Signal) erfolgt an zwei verschiedenen Punkten der Schaltung. Das von der Antenne kommende Nutzsignal wird über einen Hohlleiter in Form einer Hohlleiterwelle der im zweiten Hohlleiter 12 befindlichen Mischer-Schaltung (FIG. 2) und von dieser direkt der in Serie angeordneten ersten und zweiten Mischer-Diode 41, 42 zugeführt (FIG. 1). Wegen der seriellen Anordnung der ersten und zweiten Diode 11, 12 stellt die Mischer-Schaltung für das Nutzsignal einen Übertrager dar, welcher das Nutzsignal von der Hohlleiterimpedanz in die doppelte Diodenimpedanz überführt.

Das LO-Signal wird von der Hohlleiter-Schmalseite über eine koplanare Leiteranordnung 320 den Dioden 41, 42 zugeführt. Bezüglich der koplanaren Leiteranordnung sind die Dioden 41, 42 parallel geschaltet. Die Schaltung stellt für das LO-Signal somit einen Übertrager dar, welcher das LO-Signal von der auf der koplanaren Leitung vorliegenden Leitungsimpedanz in die halbe Dioden-Impedanz überführt.

## Patentansprüche

1. Millimeterwellen-Mischer in Fenstertechnik, bestehend aus einem einseitig metallisierten Substrat in einem rechteckförmigen Hohlleiter,
dadurch gekennzeichnet, daß
- aus der Metallisierung (212) des Substrates (211) eine Koplanarleitung (320) herausgearbeitet ist, welche die Metallisierung (212) in zwei Teile aufteilt,
- die Koplanarleitung (320) an den Schmalseiten des Hohlleiters herausgeführt sind,
- die Koplanarleitung (320) mit jeder der beiden Teile über eine erste bzw. zweite Diode (41, 42) verbunden ist,
- mindestens zwei Schlitzleitungen parallel zu den Breitseiten des Hohlleiters aus der Metallisierung (212) herausgearbeitet sind.

2. Anordnung nach Anspruch 1, dadurch gekennzeichnet, daß die Teile in etwa gleich groß sind.

3. Anordnung nach Anspruch 1 oder 2, dadurch gekennzeichnet, daß die Koplanarleitung (320) durch eine erste und eine zweite, zueinander axial ausgerichtete Koplanarleitung (321, 322) gebildet ist.

4. Anordnung nach Anspruch 3, dadurch gekennzeichnet, daß der Koppelpunkt der ersten und der zweiten Koplanarleitung (321, 322) mit dem Koppelpunkt der ersten und zweiten Diode (41, 42) galvanisch verbunden ist.

5. Anordnung nach Anspruch 4, dadurch gekennzeichnet, daß der Koppelpunkt in etwa im Flächenmittelpunkt der metallisierten Substratseite liegt.

6. Anordnung nach einem der vorherigen Ansprüche 3 bis 5, dadurch gekennzeichnet, daß zumindest der überwiegende Teil der einzelnen Schlitzleitungen (51, 52, 53, 54) jeweils parallel zur Koplanarleitung (320) verläuft.

7. Anordnung nach Anspruch 6, dadurch gekennzeichnet, daß die Schlitzleitungen (51, 52, 53, 54) jeweils in etwa λ/2 lang sind, wobei λ die mittlere Betriebswellenlänge darstellt.

8. Anordnung nach Patentanspruch 6 oder 7, dadurch gekennzeichnet, daß die Schlitzleitungen (51, 52, 53, 54) an mindestens einem ihrer Enden parallel zu einer der Schmalseiten des Hohlleiters weitergeführt sind.

9. Anordnung nach einem der Ansprüche 6 bis 8, dadurch gekennzeichnet, daß die Schlitzleitungen (51, 52, 53, 54) spiegelsymmetrisch zur Koplanarleitung (320) angeordnet sind und vorzugsweise vier Schlitzleitungen (51, 52, 53, 54) realisiert sind.

10. Anordnung nach einem der vorherigen Ansprüche, dadurch gekennzeichnet, daß an einem Ende des Hohlleiters ein Hohlleiterkurzschluß (121) realisiert ist, der zu dem Substrat (211) einen Abstand von in etwa a ≈ λ/4 aufweist, wobei λ die mittlere Betriebswellenlänge darstellt.

11. Anordnung nach einem der vorhergehenden Ansprüche, dadurch gekennzeichnet, daß
- in dem Hohlleiter (12) Hochfrequenzenergie eingespeist ist,
- von einer Schmalseite des Hohlleiters (12) auf der ersten Koplanarleitung (321) ein LO-Signal eingespeist ist,
- an der anderen Schmalseite des Hohlleiters (12) das Mischprodukt aus Hochfrequenzenergie und LO-Signal ausgekoppelt ist.

## Claims

1. Millimetre-wave mixer in window technique, consisting of a substrate, which is metallised on one side, in a rectangular waveguide, characterised in that
- a coplanar line (320) is machined out of the metallisation (212) of the substrate (211) and divides the metallisation (212) into two parts,
- the coplanar line (320) is guided out at the narrow sides of the waveguide,
- the coplanar line (320) is connected with each of the two parts by way of a first or second diode (41, 42) and
- at least two slot lines parallel to the wide sides of the waveguide machined out of the metallisation (212).

2. Arrangement according to claim 1, characterised in that the parts are approximately equal in size.

3. Arrangement according to claim 1 or 2, characterised in that the coplanar line (320) is formed by a first and a second coplanar line (321, 322) aligned axially relative to one another.

4. Arrangement according to claim 3, characterised in that the coupling point of the first and the second coplanar line (321, 322) is connected with the coupling point of the first and second diode (41, 42) by electroplating.

5. Arrangement according to claim 4, characterised in that the coupling point lies approximately at the centre point of the area of the metallised substrate side.

6. Arrangement according to one of the preceding claims 3 to 5, characterised in that at least the predominant part of the individual slot lines (51, 52, 53, 54) each time extends parallel to the coplanar line (320).

7. Arrangement according to claim 6, characterised in that the slot lines (51, 52, 53, 54) are each about λ/2 long, wherein λ represents the mean operating wavelength.

8. Arrangement according to patent claim 6 or 7, characterised in that the slot lines (51, 52, 53, 54) are extended at at least one of their ends parallel to one of the narrow sides of the waveguide.

9. Arrangement according to one of claims 6 to 8, characterised in that the slot lines (51, 52, 53, 54) are arranged in mirror symmetry to the coplanar line (320) and preferably four slot lines (51, 52, 53, 54) are realised.

10. Arrangement according to one of the preceding claims, characterised in that a waveguide short-circuit (121), which has a spacing of about a ≈ λ/4, wherein λ represents the mean operating wavelength, is realised at one end of the waveguide.

11. Arrangement according to one of the preceding claims, characterised in that
- high-frequency energy is fed into the waveguide (12),
- an LO signal is fed in from one narrow side of the waveguide (12) on the first coplanar line (321) and
- the mix product of high-frequency energy and LO signal is coupled out at the other narrow side of the waveguide (12).

## Revendications

1. Mélangeur d'ondes millimétriques réalisé selon la technique de fenêtrage, constitué par un substrat métallisé sur une face et disposé dans un guide d'ondes de forme rectangulaire,
caractérisé en ce que
- à partir de la métallisation (212) du substrat (211) est formée une ligne coplanaire (320), qui divise la métallisation (212) en deux parties,
- la ligne coplanaire (320) ressort sur les petits côtés du guide d'ondes,
- la ligne coplanaire (320) est reliée à chacune des deux parties par l'intermédiaire d'une première et d'une seconde diode (41, 42),
- au moins deux lignes à fentes sont formées à partir de la métallisation (212), parallèlement aux grands côtés du guide d'ondes.

2. Dispositif selon la revendication 1, caractérisé en ce que les parties ont des dimensions approximativement identiques.

3. Dispositif selon la revendication 1 ou 2, caractérisé en ce que la ligne coplanaire (320) est formée par des première et seconde lignes coplanaires (321, 322) qui sont orientées de manière à être coaxiales.

4. Dispositif selon la revendication 3, caractérisé en ce que le point de couplage des première et seconde lignes coplanaires (321, 322) est relié galvaniquement au point de couplage des première et seconde diodes (41, 42).

5. Dispositif selon la revendication 4, caractérisé en ce que le point de couplage est situé approximativement au centre de la surface de la face métallisée du substrat.

6. Dispositif selon l'une des revendications précédentes 3 à 5, caractérisé en ce qu'au moins la majeure partie des lignes individuelles à fentes (51, 52, 53, 54) s'étendent respectivement parallèlement à la ligne coplanaire (320).

7. Dispositif selon la revendication 6, caractérisé en ce que les lignes à fentes (51, 52, 53, 54) possèdent chacune une longueur égale approximativement à λ/2, λ représentant la longueur d'onde moyenne de service.

8. Dispositif selon la revendication 6 ou 7, caractérisé en ce que les lignes à fentes (51, 52, 53, 54) s'étendent, au moins au niveau d'une de leurs extrémités, en étant parallèles à l'un des petits côtés du guide d'ondes.

9. Dispositif selon l'une des revendications 6 à 8, caractérisé en ce que les lignes à fentes (51, 52, 53, 54) sont disposés symétriquement par rapport à la ligne coplanaire (320) et que de préférence quatre lignes à fentes (51, 52, 53, 54) sont réalisées.

10. Dispositif selon l'une des revendications précédentes, caractérisé en ce qu'à une extrémité du guide d'ondes est formé un court-circuit de guide d'ondes (121), qui est séparée du substrat (211) par une distance égale à environ a ≈ λ/4, λ étant la longueur d'onde moyenne de service.

11. Dispositif selon l'une des revendications précédentes, caractérisé en ce que
- une énergie à haute fréquence est injectée dans le guide d'ondes (12),
- un signal LO est introduit par un petit côté du guide d'ondes (12) dans la première ligne coplanaire (321),
- le produit mixte de l'énergie à haute fréquence du signal LO est découpé au niveau de l'autre petit côté du guide d'ondes (12).
